# EUROPÄISCHE PATENTSCHRIFT

(11) **EP 0 758 112 B1**
(45) Veröffentlichungstag und Bekanntmachung des Hinweises auf die Patenterteilung: **03.07.2002**
(21) Anmeldenummer: 95112549.1
(22) Anmeldetag: 09.08.1995
(51) Int. Cl.: G06F 11/20

(54) **Integrierte Halbleiter-Speichervorrichtung mit Redundanzschaltungsanordnung**
Integrated semiconductor memory device having redundancy circuit arrangement
Dispositif de mémoire à semiconducteur intégrée avec arrangement de circuits redondants

(43) Veröffentlichungstag der Anmeldung: 12.02.1997
(73) Patentinhaber: Infineon Technologies AG, 81669 München (DE)
(72) Erfinder: Rieger, Johann, 93199 Zell (DE)
(74) Vertreter: Patentanwaltskanzlei WILHELM & BECK

(56) Entgegenhaltungen:
- EP-A- 0 504 434
- DE-A- 4 241 327
- GB-A- 2 231 984

## Beschreibung

### Bezeichnung der Erfindung:

Die Erfindung bezieht sich auf eine integrierte Halbleiter-Speichervorrichtung mit einer auf dem Halbleitersubstrat der Halbleiter-Speichervorrichtung ausgebildeten Redundanz-Schaltungsanordnung für den Ersatz einer defekten Speicherzelle der integrierten Halbleiter-Speichervorrichtung durch Auswahl einer ebenfalls auf dem Halbleitersubstrat angeordneten Redundanzspeicherzelle, wobei die Speicherzellen der integrierten Halbleiter-Speichervorrichtung blockweise ausgebildet und adressierbar sind.

Bei modernen integrierten Halbleiterspeichern sind die Speicherzellen in mehreren Speicherfeldblockeinheiten angeordnet. Im Betrieb wird aus Gründen der Strom- und Zeitersparnis in Abhängigkeit von Adressignalen in der Regel jeweils nur eine Speicherfeldblockeinheit aktiviert. Zur Erhöhung der Ausbeute bei der Herstellung dieser Halbleiterspeicher ist es bekannt, redundante Leitungen mit Redundanzspeicherzellen entlang der redundanten Leitungen vorzusehen. Speicher mit mehreren Speicherfeldblockeinheiten weisen demzufolge in den Speicherfeldblockeinheiten über die normalen Bitleitungen mit normalen Speicherzellen hinaus noch ein bis beispielsweise acht oder sechzehn redundante Leitungen mit Redundanzspeicherzellen auf. Die redundanten Leitungen werden beim Betrieb im Bedarfsfall, daß heißt, wenn Redundanzspeicherzellen defekte normale Speicherzellen ersetzen sollen ("Redundanzfall"), anstelle der normalen Leitungen angesteuert. Dies erfolgt über sogenannte Redundanzdekoder, die auf die Adresse der jeweiligen normalen Leitung mit dem zu ersetzende defekten Speicherzellen programmierbar sind. Das Programmieren geschieht hierbei in an sich bekannter Weise über sogenannte Fuse-Elemente die mittels elektrischen Stromes oder mittels eines Laserstrahls unterbrechbar sind.

Aus der DE-A-42 41 327 ist eine integrierte Halbleiter-Speichervorrichtung bekannt, bei der die Redundanzspeicherzellen zu einem einheitlich von der Redundanz-Schaltungsanordnung adressierbaren Redundanzspeicherzellenfeld zusammengefaßt angeordnet sind, wobei die Redundanz-Schaltungsanordnung eine Redundanzselektionsschaltung für die Auswahl einer Redundanzspeicherzelle aus dem einheitlichen Redundanzspeicherzellenfeld für den Ersatz einer defekten Speicherzelle aus einem beliebigen Speicherzellenblock aufweist. Die Freigabe der Daten einer Speicherzelle durch den Redundanzdekoder erfolgt dabei aber erst nach Freigabe des normalen Spaltendekoders, was mit einer zeitlichen Verzögerung des Speicherzugriffs verbunden ist.

Der vorliegenden Erfindung liegt die Aufgabe zugrunde, einen integrierten Halbleiterspeicher mit einer Redundanz-Schaltungsanordnung zur Verfügung zu stellen, welche sich durch kurze Speicherzugriffszeiten sowohl im Redundanzfall als auch im Nichtredundanzfall auszeichnet.

Diese Aufgabe wird durch eine integrierte Halbleiter-Speichervorrichtung gemäß Anspruch 1 gelöst. Bevorzugte Weiterbildungen sind in den abhängigen Ansprüchen angegbenen.

Bei der erfindungsgemäßen integrierte Halbleiter-Speichervorrichtung ist die Redundanzspeicherzellen zu einem einheitlich von der Redundanz-Schaltungsanordnung adressierbaren Redundanzspeicherzellenfeld zusammengefasst, wobei die Redundanz-Schaltungsanordnung eine Redundanzselektionsschaltung für die Auswahl einer Redundanzspeicherzelle aus dem einheitlichen Redundanzspeicherzellenfeld für den Ersatz einer defekten Speicherzelle aus einem beliebigen Speicherzellenblock aufweist, so dass die Redundanzselektionsschaltung an einer bestimmten Stelle der integrierten Halbleiter-Speichervorrichtung und räumlich getrennt von jedem einzelnen Speicherblock bzw. jeder normalen Speicherzelle angeordnet bzw. ausgebildet sein kann.

Anstelle einer blockweise angeordneten Redundanzmaßnahmen sieht die erfindungsgemäßen integrierte Halbleiter-Speichervorrichtung somit vor, die Redundanzschaltungen (funktionell) zentral anzuordnen. Im Falle einer zentral angeordneten Spaltenredundanz werden zwar zusätzliche Wortdekoderschaltungen benötigt; bei dynamischen Speichern ist trotz dieses schaltungstechnischen Mehraufwandes das Flächen/Nutzenverhältnis insbesondere bei größeren Halbleiterspeichern ab etwa 16 M DRAM insgesamt günstiger als bei den bekannten verteilten Redundanzmaßnahmen. Durch die Redundanzanordnung der erfindungsgemäßen integrierten Halbleiter-Speichervorrichtung wird eine bessere Ausnutzung der Redundanzspeicherzellen ermöglicht, da Speicherzellen aus beliebigen Speicherzellenblöcken- und -einheiten durch Redundanzspeicherzellen ersetzt werden können, so daß bei gleichbleibender Zahl von Redundanzspeicherzellen wesentlich mehr Redundanzspeicherzellen verwendet werden können.

Die Redundanz-Schaltungsanordnung der erfindungsgemäßen integrierten Halbleiter-Speichervorrichtung weist weiter eine Redundanzsteuerschaltung aufweist, die in Abhängigkeit eines programmierten Redundanzselektionssignals entweder den Dateninhalt der normalen Speicherzelle oder den Dateninhalt der im Falle eines Defektes der normalen Speicherzelle entsprechend ersetzten Redundanzspeicherzelle des Redundanzspeicherzellenfeldes freigibt, wobei die Redundanzsteuerschaltung sowohl den Leseverstärkerschaltungen für die aus den normalen Speicherzellen auszulesenden Daten als auch den Leseverstärkerschaltungen für die aus den Redundanzspeicherzellen auszulesenden Redundanzdaten nachgeschaltet ist.

Die erfindungsgemäße zentrale Anordnung der Redundanz-Schaltung ermöglicht es so, die Entscheidung, ob normale oder Redundanzdaten ausgegeben werden, erst beim eigentlichen Datenausgang zu treffen. Hierdurch ergibt sich eine erhebliche Verringerung der Zugriffszeit, etwa in der Größenordnung von etwa 2 ns (2 Nanosekunden).

Die Redundanzbewerterschaltung besitzt hierbei vorzugsweise eine Programmierungseinrichtung zur festen Programmierung einer Spaltenadresse des Redundanzspeicherzellenfeldes. Die Programmierungseinrichtung wiederum besitzt zur festen Programmierung einer Spaltenadresse des Redundanzspeicherzellenfeldes vorzugsweise an sich bekannte durch Licht- oder Stromeinwirkung trennbare Fuse-Elemente.

Die Redundanzsteuerschaltung kann weiterhin eine Vergleichsschaltung mit wenigstens einer Multiplex-Schaltung aufweisen, die in Abhängigkeit des von der Programmierungseinrichtung ausgegebenen Redundanzselektionssignales aktivierbar ist.

Bei einer bevorzugten Ausführung der Erfindung ist aus Platzgründen vorgesehen, daß die Redundanz-Schaltungsanordnung am Randbereich der integrierten Halbleiter-Speichervorrichtung angeordnet ist. Von Vorteil kann die Redundanz-Schaltungsanordnung hierbei in unmittelbarer Nähe der Daten-Ein/Ausgabe-Schaltungen der Halbleiter-Speichervorrichtung angeordnet sein, um kleine Laufzeiten für das Mulitplexsignal zu erhalten.

Bei einer insbesondere bevorzugten Ausbildung der Erfindung bezieht sich diese auf die Spalten- bzw. Columnredundanz. Hierbei ist vorgesehen, daß die Redundanzspeicherzellen des einheitlich von der Redundanz-Schaltungsanordnung adressierbaren Redundanzspeicherzellenfeldes an Kreuzungspunkten von Redundanzspalten und Redundanzzeilen matrixförmig angeordnet sind, und die Redundanz-Schaltungsanordnung den Wortleitungsdekoder zur Auswahl der Redundanzzeilen anspricht. Des weiteren besitzt die Redundanzselektionsschaltung eine allgemein frei wählbare Anzahl von Redundanzspaltendekodern zur Auswahl der Redundanzspalten. Beispielsweise können bei der zentralen Spaltenredundanz gemäß der Erfindung 32 bzw. 64 Spaltenredundanzdekoder für einen universellen Einsatz vorgesehen sein, welche zu je 4 Spalten organisiert sind. Eine solche Anordnung würde insgesamt 128 bzw. 256 Spalten entsprechen. Bei einem 16 M DRAM wären dies 0.5 bis 1 Spaltenredundanzdekoder pro 256 k Speicherblock, oder 2 bis 4 redundante Spalten pro 256 k Speicherblock. Bei einer verteilten Redundanzmaßnahme wie beim Stand der Technik wären dies nur sehr wenig Reparaturmöglichkeiten. Bei einem 4 M DRAM rechnet man heute mit etwa 1.8 Spaltenreparaturen pro Chip, was hochgerechnet auf ein 16 M DRAM etwa 7.2 Spaltenreparaturen bedeuten würde. Eine Anzahl von 32 bzw. 64 Spaltenredundanzdekoder bei der erfindungsgemäßen zentralen Spaltenredundanz würde somit etwa dem 4.5- bzw. 9-fachen der üblichen Spaltenreparaturhäufigkeit entsprechen und von daher ausreichend sein.

Nachstehend wird ein Ausführungsbeispiel der Erfindung anhand der Zeichnung näher beschrieben. Es zeigt:

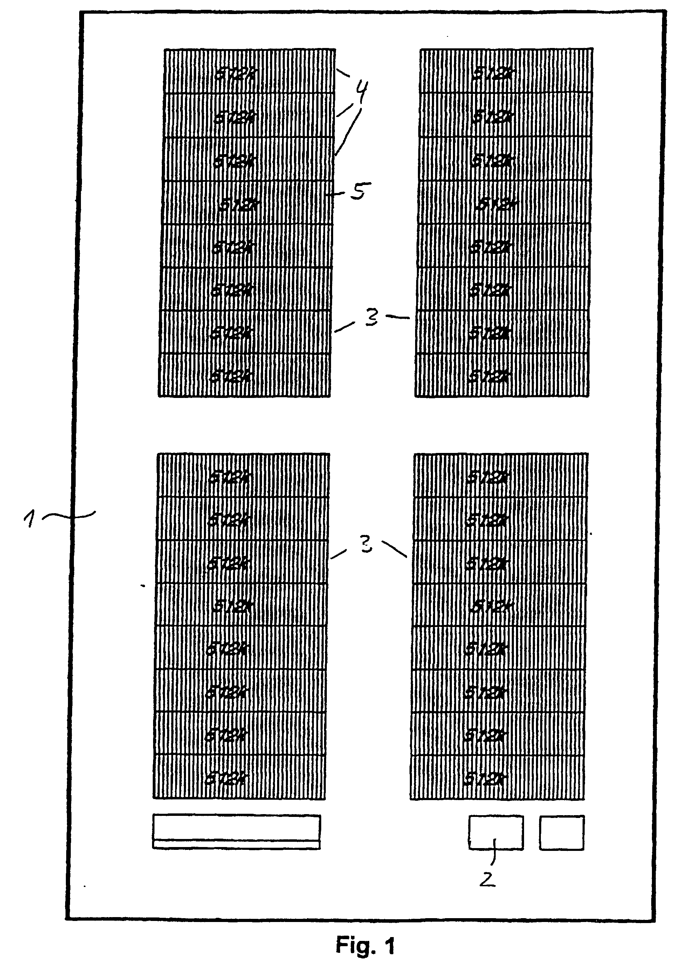

Figur 1 eine schematische Draufsicht eines 16 M DRAM mit Speicherzellen, die in Blöcken zu je 512 k angeordnet sind, sowie einer im Peripheriebereich der Speichervorrichtung angeordneten Redundanzschaltungsanordnung;
Figur 2 die bei der Halbleiter-Speichervorrichtung gemäß Fig. 1 außerhalb der Speicherzellenblöcke zusammengefaßt angeordnete Redundanzschaltungsanordnung in näheren Einzelheiten;
Figur 3 eine schematische Darstellung eines Spaltenredundanzdekoders bei der erfindungsgemäßen Halbleiter-Speichervorrichtung;
Figur 4 eine Tabelle der von dem Spaltenredundanzdekoder ausgegebenen Signale in Abhängigkeit von programmierten Zuständen der Fuse-Elemente;
Figur 5 eine schematische Darstellung zur Erläuterung der Datenverwaltung bei der erfindungsgemäßen Halbleiter-Speichervorrichtung;

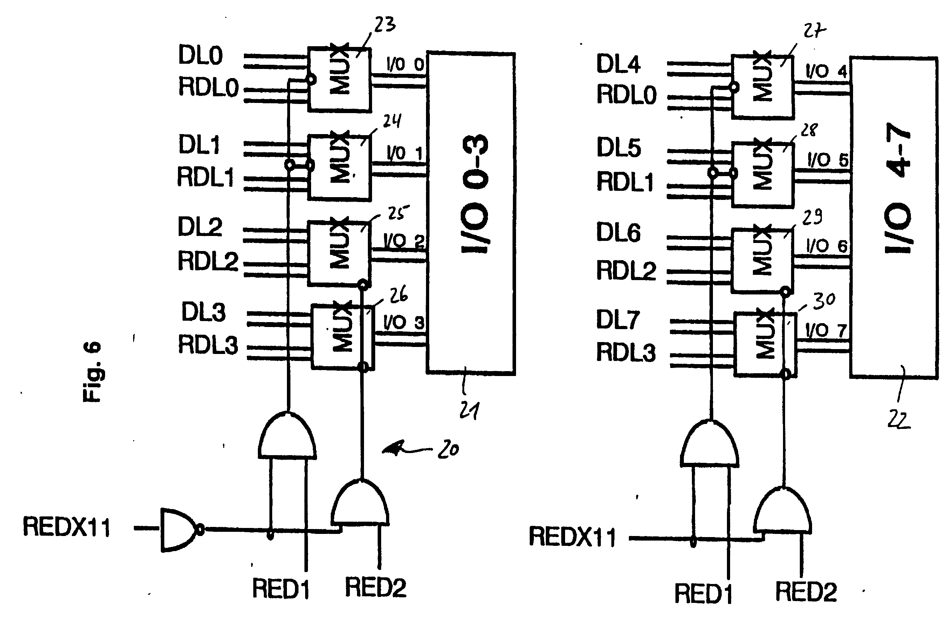

Figur 6 eine schematische Darstellung einer Redundanzbewerterschaltung bei der erfindungsgemäßen Redundanz-Schaltungsanordnung;
Figur 7 eine schematische Darstellung der Auswahl von Redundanzspalten;
Figur 8 eine schematische Darstellung der zeitlichen Abfolge der Redundanzmaßnahmen beim Stand der Technik; und
Figur 9 eine schematische Darstellung der zeitlichen Abfolge der Redundanzmaßnahmen gemäß der Erfindung.

Die Zeichnung zeigt in schematischer Darstellung eine bevorzugte Ausführungsform der erfindungsgemäßen Halbleiter-Speichervorrichtung mit einer auf einem Halbleitersubstrat 1 ausgebildeten Redundanzschaltungsanordnung 2 für den Ersatz einer defekten Speicherzelle durch eine ebenfalls auf dem Halbleitersubstrat 1 angeordneten Redundanzspeicherzelle. Soweit von aktivierten Signalen bzw. Signalen im aktivierten Zustand gesprochen wird, sollen diese Signale den Zustand "Log. 1" aufweisen, ansonsten den Zustand "Log. 0". Dies entspricht der sogenannten positiven Logik und dient lediglich einer einfacheren Darstellungsweise. Andere Logikvereinbarungen sind selbstverständlich möglich. Der dargestellte Halbleiterspeicher stellt einen 16 M dynamischen Halbleiterspeicher mit wahlfreiem Zugriff ("DRAM") dar, und besitzt eine Anzahl von vier Speicherfeldblockeinheiten 3 mit darin enthaltenen Speicherzellen. Jede Speicherfeldblockeinheit 3 wird dabei verstanden als eine Einheit mit einer Anzahl von jeweils acht Arrays bzw. Speicherzellenblöcken 4 von Speicherzellen, die in an sich bekannter Weise unabhängig voneinander aktivierbar und betreibbar sind. Die in den Blöcken 4 in jeweils einer Anzahl von 512 k angeordneten Speicherzellen 5 werden begrifflich als normale Speicherzellen bezeichnet, deren Adressierung und Betrieb ohne Zuhilfenahme von irgendwelchen Redundanzschaltungsmitteln in bekannter Weise erfolgen kann. Die normalen Speicherzellen 5 sind angeordnet entlang (und somit adressierbar über) nicht näher dargestellte normale Wortleitungen, sowie entlang von nicht näher dargestellten normalen Bitleitungen, wobei jede normale Bitleitung üblicherweise zwei Hälften enthält. An die normalen Bitleitungen sind allgemein bekannte Leseverstärker angeschlossen. Die Speicherzellen 5 sind hierbei über die jeweils zugehörigen normalen Bitleitungen und normalen Wortleitungen adressierbar mittels an den Halbleiterspeicher 1 anlegbaren Adressignalen, typischerweise im allgemein bekannten Adressmultiplexverfahren. Dabei werden zu einem ersten Zeitpunkt die für die Wortleitungsadressierung zuständigen Wortleitungsadressignale, gesteuert durch ein Taktsignal /RAS, in einem Wortleitungsadresspuffer zwischengespeichert. Entsprechend werden zu einem zweiten Zeitpunkt die für die Bitleitungsadressierung zuständigen Bitleitungsadressignale, gesteuert durch ein Taktsignal /CAS, in einem Bitleitungsadresspuffer zwischengespeichert. An den Ausgängen der Adresspuffer erscheinen diese Adressignale in True- und Komplementform.

Im Betrieb werden bei einem solchen Halbleiterspeicher nicht sämtliche Speicherfeldblockeinheiten gleichzeitig aktiviert und betrieben, sondern jeweils nur eine Speicherfeldblockeinheit. Zu diesem Zweck ist jede Speicherfeldblockeinheit mittels eines der jeweiligen Speicherfeldblockeinheit zugeordnet ten Blockauswahlsignals auswählbar. Die Auswahl erfolgt mittels eines nicht näher dargestellten Blockdekoders, der durch einen ersten Teil der Wortleitungsadressignale (und der dazu komplementären Signale) gesteuert wird.

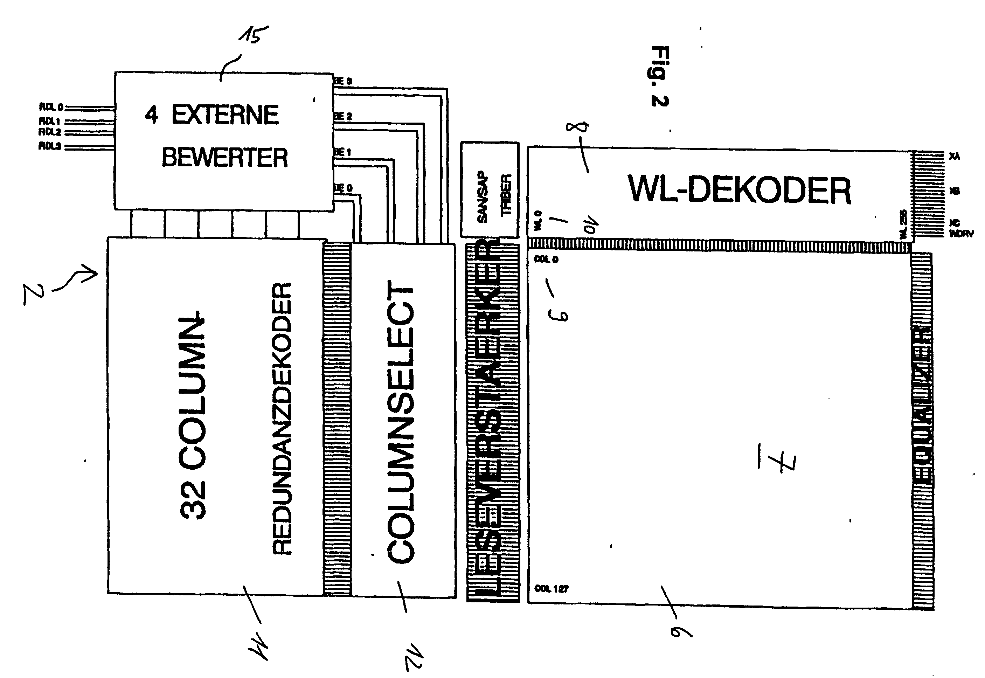

Erfindungsgemäß ist vorgesehen, daß die Redundanzspeicherzellen 6 außerhalb der Speicherzellenblöcke 4 zu einem einheit lich von der Redundanz-Schaltungsanordnung 2 adressierbaren Redundanzspeicherzellenfeld 7 zusammengefaßt angeordnet sind, und zwar sind die Redundanzspeicherzellen 6 gemäß Fig. 2 matrixförmig angeordnet und über einen Wortleitungsdekoder 8, sowie über eine Anzahl von 32 Redundanzspaltendekoder 11 adressierbar. Die Redundanzspeicherzellen 6 sind verwendbar, um mit Fehler behaftete normale Speicherzellen zu ersetzen, wobei der Fehler sowohl in den zu ersetzenden Speicherzellen selbst oder im Zusammenhang mit deren Betrieb auftreten kann, beispielsweise Fehler bei den zugeordneten Bitleitungen, Leseverstärkern, Adressdekodern.

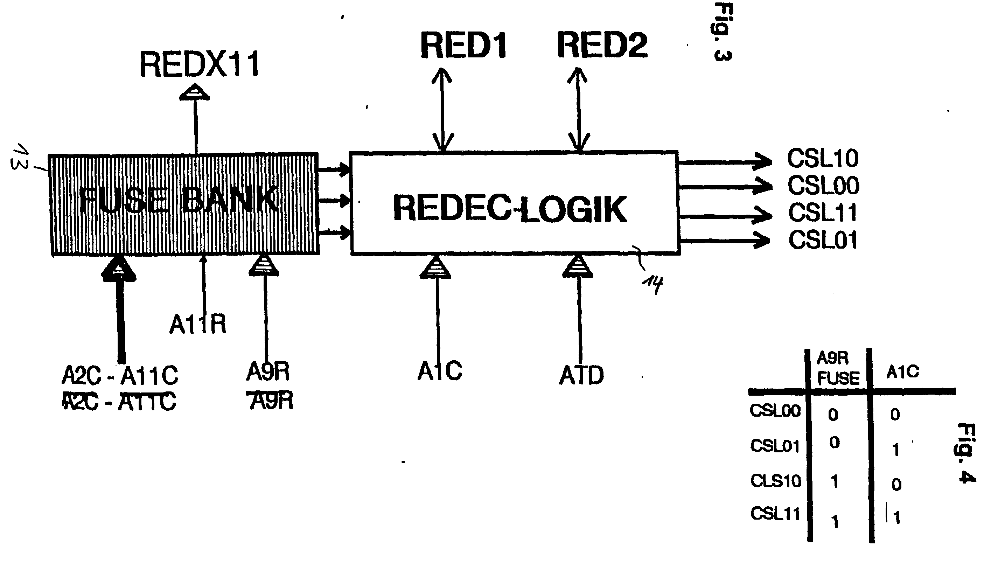

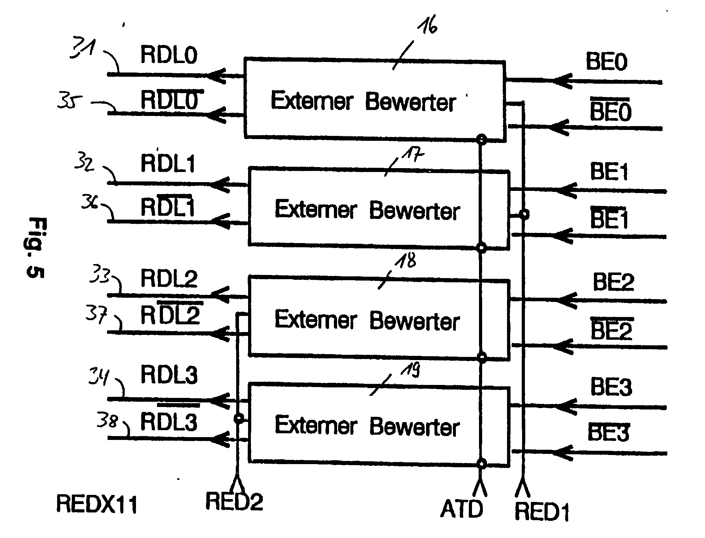

Im dargestellten Fall sind die Redundanzspeicherzellen 6 des Redundanzspeicherzellenfeldes 7 matrixförmig in 128 Redundanzspalten 9 und 256 Wortleitungen 10 organisiert und werden vermittels des Wortleitungsdekoders 8 und der Anzahl von 32 Redundanzspaltendekodern 11, die einer in der Redundanz-Schaltungsanordnung 2 vorgesehenen Redundanzspaltenauswahlschaltung 12 zugeordnet sind, ausgewählt. Jeder der 32 Redundanzspaltendekoder ist schaltungstechnisch gleich aufgebaut und besitzt die in Fig. 3 näher erläuterten Bestandteile. Zur Adressierung der Redundanzspeicherzellen 6 ist eine programmierbare Fusebank 13 mit einer der Anzahl der ansteuerbaren Redundanzspeicherzellen 6 entsprechenden Anzahl von lasertrennbaren Fuseeinheiten vorgesehen, die den angelegten Adreßsignalen A2C bis A11C bzw. /A2C bis /A11C zugeordnet sind und ein Redundanzauswahlsignal REDX11 für die Unterscheidung, ob Datenbits in der Datenleitung DL0 bis DL3 oder der Datenleitung DL4 bis DL7 ersetzt werden sollen, erzeugen. Das Signal REDX11 wird hierbei in Abhängigkeit, ob eine der Adresse A11R zugeordnete Fuseeinheit aktiviert ist oder nicht, ausgegeben. Der programmierbaren Fusebank 13 ist eine Redundanzdekoderlogikschaltung 14 nachgeschaltet, die in Abhänggigkeit der von der Fusebank 13 programmierten Redundanzauswahlsignale die zur Ansteuerung der jeweiligen Redundanzspaltendekoder 11 benötigten Spaltenauswahlsignale CSL10, CSL00, CSL11, CSL01 erzeugt. Darüber hinaus werden hier in Abhängigkeit einer Blockauswahladresse A1C und eines Adreßfreigabesignales ATD (= adress transient data) entweder die jeweils linke Blockhälfte mit RED1 oder die jeweils rechte Blockhälfte mit RED2 eines 512k Blocks ausgewählt, wobei RED1 und RED2 gleichzeitig anliegen können und von der Fuseeinheit A9R des ausgewählten Redundanzdekoders bestimmt werden. Somit können bis zu zwei Redundanzdekoder gleichzeitig ausgewählt sein. In der in Fig. 4 dargestellten Tabelle ist ein Beispiel der Spaltenauswahlsignale CSL10, CSL00, CSL11, CSL01 in Abhängigkeit der logischen Zustände der Fuseeinheit A9R und des Adressignales A1C gezeigt.

Fig. 5 zeigt in näheren Einzelheiten eine den 32 Redundanzspaltendekodern 11 und der Redundanzspaltenauswahlschaltung 12 zugeordnete Bewerterschaltung 15 mit vier externen Leseverstärkern 16, 17, 18, 19, an denen die von der Redundanzspaltenauswahlschaltung 12 ausgegebenen Bitleitungssignale BE0 bis BE3 und die entsprechend komplementären Bitleitungssignale /BE0 bis /BE3, und die vom Redundanzspaltendekoder 11 ausgegebenen Signale RED1 und RED2, sowie ATD zugeführt sind, und Redundanzdaten RDL0 bis RDL3 und komplementäre Redundanzdaten /RDL0 bis /RDL3 auf den Redundanzdatenleitungen 31, 32, 33, 34 und komplementären Redundanzdatenleitungen 35, 36, 37, 38 ausgegeben werden. Die Redundanzdatenleitungen 35, 36, 37, 38 und die normalen Datenleitungen DL0 bis DL7 werden mit einem Logiksignal 20, welches den Multiplexer (MUX) 23 bis 30 schaltet, gemultiplext. Der Multiplexer schaltet in Abhängigkeit von RED1, RED2 die Redundanzdatenleitungen, oder die normalen Datenleitungen zum Datenausgang (I/O) durch.

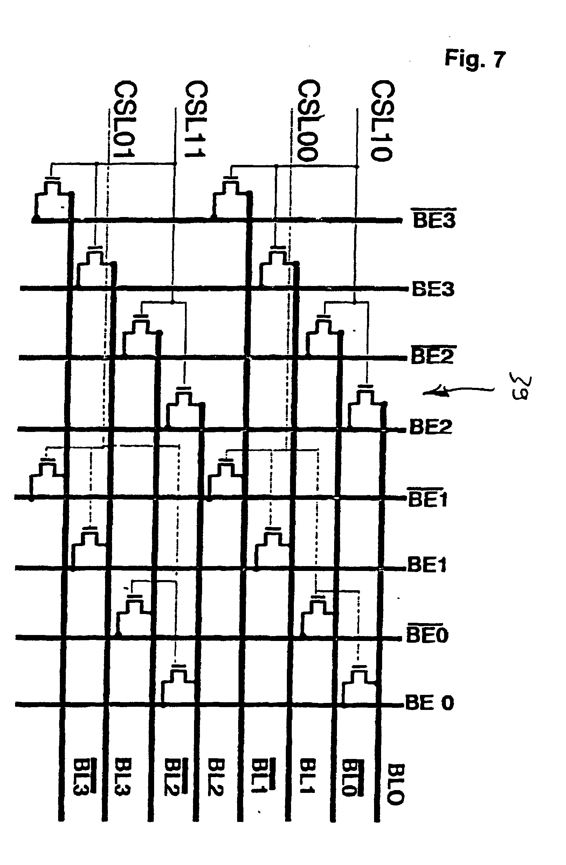

In Fig. 7 ist des weiteren eine beispielhafte Schaltmatrix 39 dargestellt, die der Redundanzspaltenauswahlschaltung 12 zugeordnet sein kann, um in Abhängigkeit der Spaltenauswahlsignale CSL10, CSL00, CSL11, CSL01 eine Umformung der auf den Bitleitungen BL0 bis BL3, sowie komplementären Bitleitungen /BL0 bis /BL3 anstehenden Bitleitungssignale des Redundanzspeicherzellenfeldes 7 in Signale BE0 bis BE3 und komplementäre Signale /BE0 bis /BE3 auszubilden, welche der Leseverstärkerschaltung 15 zugeführt werden.

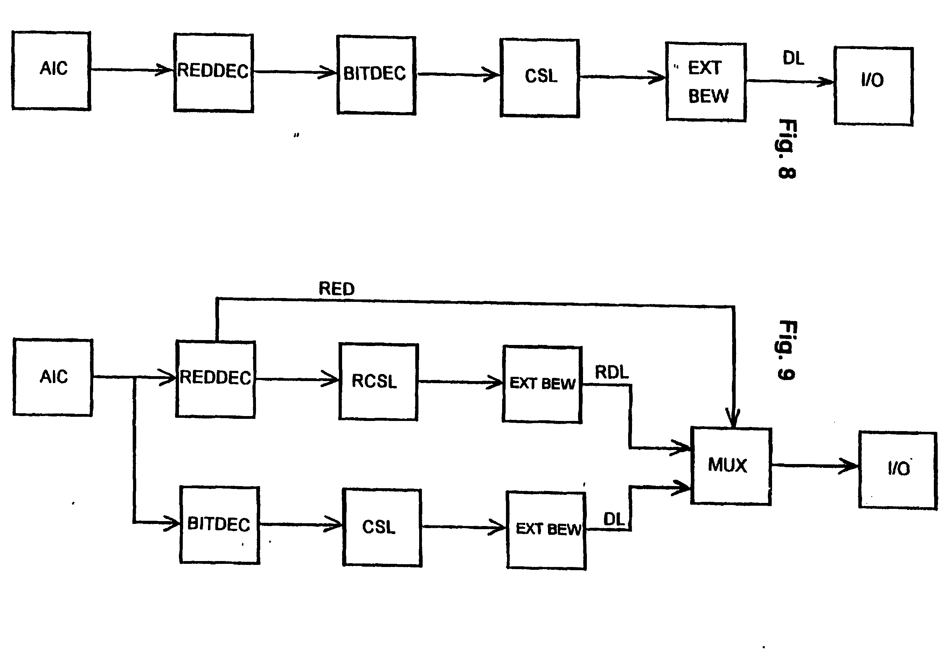

Anhand der schematischen Darstellungen gemäß Fig. 8 und Fig. 9 wird nochmals der erfindungsgemäße Vorteil hinsichtlich einer kürzeren Zugriffszeit erläutert. Die in den Fig. 8 und Fig. 9 verwendeten Abkürzungen bezeichnen hierbei in verkürzter Form folgende Bestandteile: AIC = Adress Input Column (Eingabe Spaltenaddresse), REDDEC = Redundanzdekoder, BITDEC = Bitleitungsdekoder, CSL = Columnselect (Spaltenauswahl), EXT BEW = Externer Bewerter (Externer Leseverstärker), DL = Datenleitung, I/O = In/Out-Schaltung (Ein/Ausgabeschaltung), RCSL = Redundanz Column Select (Redundanzspaltenauswahl), MUX = Multiplexer. Während bei der bisherigen Lösung gemäß Fig. 8 der normale Columndekoder in jedem Fall vom Redundanzdekoder freigegeben werden muß, wird bei der erfindungsgemäßen Lösung gemäß Fig. 9 die Entscheidung, ob normale oder Redundanzdaten ausgegeben werden, erst beim eigentlichen Datenausgang getroffen, so daß ein Geschwindigkeitsvorteil von etwa 2 ns ermöglicht wird.

## Patentansprüche

1. Integrierte Halbleiter-Speichervorrichtung mit einer auf einem Halbleitersubstrat (1) der Halbleiter-Speichervorrichtung ausgebildeten Redundanz-Schaltungsanordnung (2) für den Ersatz einer defekten Speicherzelle (5) der integrierten Halbleiter-Speichervorrichtung durch Auswahl einer ebenfalls auf dem Halbleitersubstrat (1) angeordneten Redundanzspeicherzelle (6), wobei die Speicherzellen (5) der integrierten Halbleiter-Speichervorrichtung blockweise ausgebildet und adressierbar sind, die Redundanzspeicherzellen (6) zu einem einheitlich von der Redundanz-Schaltungsanordnung (2) adressierbaren Redundanzspeicherzellenfeld (7) zusammengefaßt angeordnet sind, und die Redundanz-Schaltungsanordnung (2) eine Redundanzselektionsschaltung (13, 14, 15, 20) für die Auswahl einer Redundanzspeicherzelle (6) aus dem einheitlichen Redundanzspeicherzellenfeld (7) für den Ersatz einer defekten Speicherzelle (5) aus einem beliebigen Speicherzellenblock (4) aufweist,
**dadurch gekennzeichnet, daß**
die Redundanz-Schaltungsanordnung (2) eine Redundanzsteuerschaltung (15, 20, 23 bis 30) aufweist, die in Abhängigkeit eines programmierten Redundanzselektionssignals (REDX) entweder den Dateninhalt der normalen Speicherzelle (5) oder den Dateninhalt der im Falle eines Defektes der normalen Speicherzelle entsprechend ersetzten Redundanzspeicherzelle (6) des Redundanzspeicherzellenfeldes (7) freigibt, wobei die Redundanzsteuerschaltung (15, 20, 23 bis 30) sowohl den Leseverstärkerschaltungen für die aus den normalen Speicherzellen auszulesenden Daten, als auch den Leseverstärkerschaltungen (16, 17, 18, 19) für die aus den Redundanzspeicherzellen auszulesenden Redundanzdaten nachgeschaltet ist.

2. Halbleiter-Speichervorrichtung nach Anspruch 1, **dadurch gekennzeichnet, daß** die Redundanzselektionsschaltung (13, 14, 15, 20) an einer bestimmten Stelle der integrierten Halbleiter-Speichervorrichtung und räumlich getrennt von jedem einzelnen Speicherzellenblock (4) bzw. jeder normalen Speicherzelle (5) angeordnet bzw. ausgebildet ist.

3. Halbleiter-Speichervorrichtung nach Anspruch 1 oder 2, **dadurch gekennzeichnet, daß** die Redundanz-Schaltungsanordnung (2) am Randbereich der integrierten Halbleiter-Speichervorrichtung angeordnet ist.

4. Halbleiter-Speichervorrichtung nach Anspruch 1 bis 3, **dadurch gekennzeichnet, daß** die Redundanz-Schaltungsanordnung (2) in unmittelbarer Nähe der Daten-Ein/Ausgabe-Schaltungen (21, 22) der Halbleiter-Speichervorrichtung angeordnet ist.

5. Halbleiter-Speichervorrichtung nach Anspruch 1 bis 4, **dadurch gekennzeichnet, daß** die Redundanzspeicherzellen (6) des einheitlich von der Redundanz-Schaltungsanordnung (2) adressierbaren Redundanzspeicherzellenfeldes (7) an Kreuzungspunkten von Redundanzspalten (9) und Redundanzzeilen (10) matrixförmig angeordnet sind, und die Redundanz-Schaltungsanordnung (2) einen Wortleitungsdekoder (8) zur Auswahl der Redundanzzeilen (10), und die Redundanzselektionsschaltung eine Anzahl von Redundanzspaltendekodern (11) zur Auswahl der Redundanzspalten (9) aufweist.

6. Halbleiter-Speichervorrichtung nach Anspruch 1 bis 5, **dadurch gekennzeichnet, daß** ein Redundanzspaltendekoder (11) gleichzeitig mit dem Zugriff auf eine Spalte eines Speicherzellenblockes (4) durch Auswahl einer Bitleitung für die normalen Speicherzellen auf das einheitlich von der Redundanz-Schaltungsanordnung adressierbare Redundanzspeicherzellenfeld (7) zugreift.

7. Halbleiter-Speichervorrichtung nach Anspruch 1 bis 6, **dadurch gekennzeichnet, daß** der Redundanzsteuerschaltung (15, 20 23 bis 30) eine Programmierungseinrichtung (13) zur festen Programmierung einer Adresse des Redundanzspeicherzellenfeldes (7) zugeordnet ist.

8. , Halbleiter-Speichervorrichtung nach Anspruch 7, **dadurch gekennzeichnet, daß** die Programmierungseinrichtung (13) zur festen Programmierung einer Spaltenadresse des Redundanzspeicherzellenfeldes (7) durch Licht- oder Stromeinwirkung trennbare Fuse-Elemente besitzt.

9. Halbleiter-Speichervorrichtung nach Anspruch 7 oder 8, **dadurch gekennzeichnet, daß** die Redundanzsteuerschaltung (15, 20, 23 bis 30) eine Logikschaltung (20) mit wenigstens einer Multiplex-Schaltung aufweist, die in Abhängigkeit des von der Programmierungseinrichtung (13) ausgegebenen Redundanzselektionssignals (REDX) aktivierbar ist.

10. Halbleiter-Speichervorrichtung nach Anspruch 1 bis 9, **dadurch gekennzeichnet, daß** die Halbleiter-Speichervorrichtung einen dynamischer Halbleiterspeicher mit wahlfreiem Zugriff (DRAM) darstellt.

11. Halbleiter-Speichervorrichtung nach Anspruch 10, **dadurch gekennzeichnet, daß** der dynamische Halbleiterspeicher mit wahlfreiem Zugriff eine Speicherzellenanzahl von 16 Mega, 64 Mega, 256 Mega oder mehr darstellt, und das Redundanzspeicherzellenfeld vorzugsweise 256 Wortleitungen und 64-1k Redundanzbitleitungen aufweist.

## Claims

1. Integrated semiconductor memory device having a redundancy circuit arrangement (2), formed on a semiconductor substrate (1) of the semiconductor memory device, for the replacement of a defective memory cell (5) of the integrated semiconductor memory device by the selection of a redundancy memory cell (6), likewise arranged on the semiconductor substrate (1), the memory cells (5) of the integrated semiconductor memory device being formed and addressable in blocks, the redundancy memory cells (6) being arranged such that they are combined to form a redundancy memory cell array (7) which can be addressed uniformly by the redundancy circuit arrangement (2), and the redundancy circuit arrangement (2) having a redundancy selection circuit (13, 14, 15, 20) for the selection of a redundancy memory cell (6) from the uniform redundancy memory cell array (7) for the replacement of a defective memory cell (5) from an arbitrary memory cell block (4),
**characterized in that**
the redundancy circuit arrangement (2) has a redundancy control circuit (15, 20, 23 to 30), which, depending on a programmed redundancy selection signal (REDX), enables either the data content of the normal memory cell (5) or the data content of the redundancy memory cell (6) of the redundancy memory cell array (7), which redundancy memory cell is correspondingly replaced in the case of a defect in the normal memory cell, the redundancy control circuit (15, 20, 23 to 30) being connected downstream both of the sense amplifier circuits for the data that are to be read from the normal memory cells, and of the sense amplifier circuits (16, 17, 18, 19) for the redundancy data that are to be read from the redundancy memory cells.

2. Semiconductor memory device according to Claim 1, **characterized in that** the redundancy selection circuit (13, 14, 15, 20) is arranged or formed at a specific location of the integrated semiconductor memory device and in a manner spatially separate from each individual memory cell block (4) or each normal memory cell (5).

3. Semiconductor memory device according to Claim 1 or 2, **characterized in that** the redundancy circuit arrangement (2) is arranged at the edge region of the integrated semiconductor memory device.

4. Semiconductor memory device according to Claims 1 to 3, **characterized in that** the redundancy circuit arrangement (2) is arranged in direct proximity to the data input/output circuits (21, 22) of the semiconductor memory device.

5. Semiconductor memory device according to Claims 1 to 4, **characterized in that** the redundancy memory cells (6) of the redundancy memory cell array (7) which can be addressed uniformly by the redundancy circuit arrangement (2) are arranged in matrix form at crossover points of redundancy columns (9) and redundancy rows (10), and the redundancy circuit arrangement (2) has a word line decoder (8) for the selection of the redundancy rows (10), and the redundancy selection circuit has a number of redundancy column decoders (11) for the selection of the redundancy columns (9).

6. Semiconductor memory device according to Claims 1 to 5, **characterized in that** a redundancy column decoder (11) accesses the redundancy memory cell array (7), which can be addressed uniformly by the redundancy circuit arrangement, at the same time as the access to a column of a memory cell block (4) by the selection of a bit line for the normal memory cells.

7. Semiconductor memory device according to Claims 1 to 6, **characterized in that** the redundancy control circuit (15, 20, 23 to 30) is assigned a programming device (13) for fixed programming of an address of the redundancy memory cell array (7).

8. Semiconductor memory device according to Claim 7, **characterized in that** the programming device (13) for fixed programming of a column address of the redundancy memory cell array (7) has fuse elements which can be separated by the action of light or current.

9. Semiconductor memory device according to Claim 7 or 8, **characterized in that** the redundancy control circuit (15, 20, 23 to 30) has a logic circuit (20) with at least one multiplex circuit which can be activated in a manner dependent on the redundancy selection signal (REDX) output by the programming device (13).

10. Semiconductor memory device according to Claims 1 to 9, **characterized in that** the semiconductor memory device constitutes a dynamic random access semiconductor memory (DRAM).

11. Semiconductor memory device according to Claim 10, **characterized in that** the dynamic random access semiconductor memory constitutes a number of memory cells of 16 mega, 64 mega, 25 mega or more, and the redundancy memory cell array preferably has 256 word lines and 64-1k redundancy bit lines.

## Revendications

1. Dispositif de mémoire à semiconducteur intégré, comprenant un circuit (2) de redondance constitué sur un substrat (1) semiconducteur du dispositif de mémoire à semiconducteur pour le remplacement d'une cellule (5) défectueuse de mémoire du dispositif de mémoire à semiconducteur intégré par le choix d'une cellule (6) de mémoire redondante disposée également sur le substrat (1) semiconducteur, les cellules (5) de mémoire du dispositif de mémoire à semiconducteur intégré étant constituées bloc par bloc et pouvant être adressées, les cellules (6) de mémoire redondante étant rassemblées en un champ (7) de cellules de mémoire redondantes pouvant être adressées de manière unitaire par le circuit (2) de redondance et le circuit (2) de redondance comportant un circuit (13, 14, 15, 20) de sélection de redondance pour le choix d'une cellule (6) de mémoire redondante dans le champ (7) de cellules de mémoire redondantes unitaire pour le remplacement d'une cellule (5) défectueuse de mémoire dans n'importe quel bloc (4) de cellules de mémoire,
**caractérisé en ce que** le circuit (2) de redondance comporte un circuit (15, 20, 23 à 30) de commande de redondance, qui libère en fonction d'un signal (REDX) de sélection de redondance programmé soit le contenu de données de la cellule (5) normale de mémoire, soit le contenu de données de la cellule (6) de mémoire redondante du champ (7) de cellules de mémoire redondantes qui est remplacée de manière correspondante dans le cas d'un défaut de la cellule de mémoire normale, le circuit (15, 20, 23 à 30) de commande de redondance étant monté en aval tant des circuits amplificateurs de lecture des données à lire dans les cellules normales de mémoire que des circuits (16, 17, 18, 19) amplificateurs de lecture des données redondantes à lire dans les cellules redondantes de mémoire.

2. Dispositif de mémoire à semiconducteur suivant la revendication 1, **caractérisé en ce que** le circuit (13, 14, 15, 20) de sélection de redondance est disposé ou est constitué en un point déterminé du dispositif de mémoire à semiconducteur intégré et en étant séparés dans l'espace de chaque bloc (4) de cellules de mémoire ou de chaque cellule (5) normale de mémoire.

3. Dispositif de mémoire à semiconducteur suivant la revendication 1 ou 2, **caractérisé en ce que** le circuit (2) de redondance est disposé sur la partie de bord du dispositif de mémoire à semiconducteur intégré.

4. Dispositif de mémoire à semiconducteur suivant la revendication 1 à 3, **caractérisé en ce que** le circuit (2) de redondance est disposé à proximité immédiate des circuits (21, 22) d'entrée/sortie de données du dispositif de mémoire à semiconducteur.

5. Dispositif de mémoire à semiconducteur suivant les revendications 1 à 4, **caractérisé en ce que** les cellules (6) de mémoire redondantes du champ (7) de cellules de mémoire redondantes pouvant être adressées de manière unitaire par le circuit (2) de redondance sont disposées aux points d'intersection de colonnes (9) de redondance et de lignes (10) de redondance sous la forme d'une matrice, et le circuit (2) de redondance comporte un décodeur (8) de lignes de mot destiné à sélectionner les lignes (10) de redondance et le circuit de sélection de redondance comporte un certain nombre de décodeurs (11) de colonnes de redondance destinés à sélectionner les colonnes de redondance.

6. Dispositif de mémoire à semiconducteur suivant la revendication 1 à 5, **caractérisé en ce qu'**un décodeur (11) de colonnes de redondance a accès, en même temps qu'il a accès à une colonne d'un bloc (4) de cellules de mémoire par sélection d'une ligne de bit pour les cellules normales de mémoire, au champ (7) de cellules de mémoire redondantes qui peut être adressé de manière unitaire par le circuit de redondance.

7. Dispositif de mémoire à semiconducteur suivant la revendication 1 à 6, **caractérisé en ce qu'**il est associé au circuit (15, 20, 23 à 30) de commande de redondance un dispositif (13) de programmation pour programmer de manière fixe une adresse du champ (7) de cellules de mémoire redondantes.

8. Dispositif de mémoire à semiconducteur suivant la revendication 7, **caractérisé en ce que** le dispositif (13) de programmation comporte, pour programmer de manière fixe une adresse de colonne du champ (7) de cellules de mémoire redondantes des éléments à fusibles pouvant être coupés par l'action de la lumière ou du courant.

9. Dispositif de mémoire à semiconducteur suivant la revendication 7 ou 8, **caractérisé en ce que** le circuit (15, 20, 23 à 30) de commande de résonance comporte un circuit (20) logique ayant au moins un circuit ou multiplexeur qui peut être activé en fonction du signal (REDX) de sélection de redondance émis par le dispositif (13) de programmation.

10. Dispositif de mémoire à semiconducteur suivant la revendication 1 à 9, **caractérisé en ce que** le dispositif de mémoire à semiconducteur constitue une mémoire dynamique à semiconducteur à accès aléatoire (DRAM).

11. Dispositif de mémoire à semiconducteur suivant la revendication 10, **caractérisé en ce que** la mémoire dynamique à semiconducteur a accès aléatoire représente un nombre de cellules de mémoire de 16 méga, 64 méga, 256 méga ou plus et **en ce que** le champ de cellules de mémoire redondantes comporte de préférence 256 lignes de mots et 64-1k lignes de bits de redondance.
